(19) Europäisches Patentamt
European Patent Office
Office européen des brevets

(11) Veröffentlichungsnummer: **0 002 726**
**B1**

(12) # EUROPÄISCHE PATENTSCHRIFT

(45) Veröffentlichungstag der Patentschrift: **25.11.81**

(21) Anmeldenummer: **78101659.7**

(22) Anmeldetag: **13.12.78**

(51) Int. Cl.³: **H 01 J 37/305,**
H 01 J 37/08, H 01 J 37/05

(54) **Verfahren und Einrichtung zum reaktiven Ionenätzen.**

(30) Priorität: **30.12.77 US 865811**

(43) Veröffentlichungstag der Anmeldung:
**11.07.79 Patentblatt 79/14**

(45) Bekanntmachung des Hinweises auf die Patenterteilung:
**25.11.81 Patentblatt 81/47**

(84) Benannte Vertragsstaaten:
**DE FR GB**

(56) Entgegenhaltungen:
**US - A - 3 969 646**

**Journal of Vacuum Science and Technology, vol. 13, nr. 5, Seiten 1023—1029 (1976) New York, U.S.A.
BONDUR: "Dry Process technology (reactive ion etching)"
*Seite 1024 (Reaction theory)***

**Product Engineering, vol. 40, Nr. 6, (1969) New York, U.S.A. Seiten 84—86**

(73) Patentinhaber: **International Business Machines Corporation
Armonk, N.Y. 10504 (US)**

(72) Erfinder: **Keller, John Howard
7 Dutchess Court
Newburgh N.Y. 12550 (US)**
Erfinder: **Mc Kenna, Charles Michael
7 Wedgewood Road
Fishkill N.Y. 12524 (US)**

(74) Vertreter: **Neuland, Johannes, Dipl.-Ing.
Schönaicher Strasse 220
D-7030 Böblingen (DE)**

**EP 0 002 726 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# Verfahren und Einrichtung zum reaktiven Ionenätzen

Die Erfindung bezieht sich auf ein Verfahren und eine Einrichtung zum reaktiven Ionenätzen.

Beim Herstellen von Halbleiterschaltungen ist Ätzen erforderlich, um Bereiche des Siliciumsubstrates für Diffusion oder Ionenimplantation von Störstellen freizulegen, so daß monolithitisch integrierte Halbleiterschaltungen in dem Siliciumsubstrat gebildet werden können. Ein Ätzverfahren ist das Plasmaätzen oder reaktive Ionenätzen. Bei diesem Verfahren wird ein chemisch reaktionsfreudiges Gas, wie $CF_4$ verwendet. Die Oberfläche des zu ätzenden Siliciumsubstrates wird mit einer Maske bedeckt, die ausgewählte Bereiche der Oberfläche freiläßt. Das Substrat mit einer zu ätzenden Fläche wird in eine Kammer eingesetzt, die ein reaktionsfreudiges Gas enthält. Um das Plasma zu erzeugen, wird normalerweise eine Hochfrequenzspannung an das Gas angelegt, um es zu veranlassen, zu dissoziieren und verschiedene positive und negative Ionen zu bilden.

Sehr reaktionsfreudige Arten, wie die Halogene und Sauerstoff, sind, besonders in ihrer atomaren Form, ob neutral oder ionisiert, zum Ätzen von Metallen, Silicium und Oxiden und Nitriden von Silicium zu bevorzugen. Atomares Fluor aus einem Plasma, das aus einem Gas von $CF_4$ mit einem kleinen Prozentsatz von Sauerstoff erzeugt wurde, reagiert mit Silicium und den Oxiden und Nitriden von Silicium gemäß den folgenden Reaktionsgleichungen:

$$CF_4 \rightarrow C + 4F$$

$$4F + Si \rightarrow SiF_4$$

$$4F + SiO_2 \rightarrow SiF_4 + O_2$$

$$12F + Si_3N_4 \rightarrow 3SiF_4 + 2N_2$$

Das Ätzen oder Veraschen von organischem Material, wie einem Photolack, erfolgt vorzugsweise auch mit atomarem Sauerstoff. Eine allgemeine Reaktionsgleichung ist die folgende:

$$C_xH_y + 3O \rightarrow CO_2 + H_2O$$

Es ist erwünscht, einen Ätzmittelfluß zu erzielen, der gegenüber dem zu ätzenden Substrat angereichert ist mit diesen reaktionsfreudigen Arten. Diese reaktionsfreudigen Arten sind gekennzeichnet durch hohe Elektronegativität. Wenn jedoch ein positives Potential angelegt wird, um diese Arten zum Substrat hin anzuziehen, werden Elektronen ebenfalls angezogen und das Plasma zerfällt.

Hier will die Erfindung Abhilfe schaffen. Die Erfindung, wie sie in den Ansprüchen gekennzeichnet ist, löst die Aufgabe, ein Verfahren und eine Einrichtung anzugeben, die diese elektronegative Eigenschaft für das Trennen und Extrahieren dieser sehr reaktionsfreudigen Arten als negative Ionen aus dem Plasma ausnutzt, während die freien Elektronen im wesentlichen in dem Plasma zurückgehalten werden.

Im folgenden werden bevorzugte Ausführungsbeispiele der Erfindung in Verbindung mit den Zeichnungen näher erläutert, von denen zeigen:

Fig. 1 einen Querschnitt des bevorzugten Plasma-Reaktionsapparates mit dem eingebauten ferromagnetischen Gitter gemäß der Erfindung;

Fig. 2 eine Querschnitt eines alternativen Plasma-Reaktionsapparates mit eingebautem ferromagnetischen Gitter gemäß der Erfindung;

Fig. 3 eine vergrößerte Draufsicht auf das ferromagnetische Gitter gemäß der Erfindung und

Fig. 4 eine noch stärker vergrößerte perspektivische Ansicht, die den Einfluß des magnetischen Feldes auf ein Elektron in einem Luftspalt des ferromagnetischen Gitters darstellt.

Der in Fig. 1 dargestellte Apparat enthält eine Hochvakuumanlage 10, die in einen oberen Teil 11 geteilt ist, dem ein plasmabildendes Gas über durch Ventile gesteuerte Röhren 12, 13 zugeführt wird, und einen unteren Teil 14, mit dem eine Vakuumpumpe 15 verbunden ist. Eine Reihe sich nach innen erstreckender Magnetpolstücke 16 ist auf Seitenwänden 17, 18 und auf der oberen Wand 19 und rings herum im Inneren des oberen Teiles 11 angeordnet. Eine (nicht dargestellte) magnetische Vorrichtung ist mit den Polstücken 16 so gekoppelt, daß nebeneinanderliegende Pole die entgegengesetzte Polarität aufweisen und ein magnetisches Feld den Zwischenraum zwischen ihnen überbrückt. In der Mitte jeder der vier Wände ist ein Heizfadenhalter angeordnet zum Halten eines Heizfadens oder einer Kathode 21, ungefähr in der Mitte des oberen Teiles 11. Der Heizfaden 21 wird durch Gleich- oder Wechselstrom auf Temperaturen erhitzt, die ausreichen, um eine thermische Emission zu erzeugen (ungefähr 2500°C). Ein Gleichspannungspotential in der Größenordnung von 50 Volt wird an den Heizfaden 21 angelegt und veranlaßt das Gas, zu ionisieren und ein Plasma zu bilden. Eine genauere Beschreibung dieses Reaktortyps mit einer Ionenquelle findet sich in der Veröffentlichung "Ion Sources for Ion Machining Applications", von H. F. Kaufman, P. D. Reader und G. C. Isaacson, Journal AIAA, Vol. 15, Nr. 6, Juni 1977, Seiten 843—847.

Sowohl positive als auch negative Ionen und Radikale sind in dem Plasma sowohl in molekularer

als auch in atomarer Form vorhanden. Beim reaktiven Ionenätzen werden diese Ionen zu einem Substrat 22 gelenkt, das von der Basis 23 der Vakuumkammer 10 getragen wird, wo sie mit den Siliciumscheiben 24 reagieren. Dieser Ätzprozeß schließt eine chemische Reaktion ein, die sich mit einem physikalischen Ätzprozeß verbindet. Da der Prozeß von der Richtung der Ionenart abhängt, die durch das elektrische Feld bestimmt wird, kann das seitliche Unterätzen der Masken verringert werden, wenn das erwünscht ist und es können nahezu senkrechte Ätzstufen erzeilt werden.

Die Ätzgeschwindigkeit kann dadurch erhöht werden, daß in der Hauptsache negative Ionen, insbesondere in atomarer Form, und Radikale mit dem Substrat reagieren, da sie stärker mit ihm reagieren, wenn es entweder aus Silicium und seinen Oxiden und Nitriden besteht oder aus organischem Material, wie einem Photolack. Gemäß der Erfindung ist eine magnetische Vorrichtung zwischen den oberen Teil 11 und dem unteren Teil 14 der Vakuumkammer 10 so angeordnet, daß, wenn ein positives Potential an den unteren Teil 14 angelegt wird, um die negativen Ionen und/oder Radikale anzuziehen, ein Magnetfeld aufgebaut wird, das im wesentlichen senkrecht zu der Richtung des Weges der Ionen verläuft und von genügender Größe ist, um die Elektronen am Erreichen des Substrates zu hindern, das aber nicht stark genug ist, um die negativen Ionen am Erreichen der Halbleiterscheiben 24 auf dem Substrat zu hindern.

In dem vorliegenden Ausführungsbeispiel enthält die Magnetvorrichtung eine ferromagnetische Gitterelektrode 25, die aus Weicheisen besteht und ein Joch 26 aufweist, um den magnetischen Kreis von der einen Seite 26a der als Quelle dienenden Elektrode 25 zu deren anderer Seite 26b zu schließen, wobei die Elektrode 25 und das Joch 26 durch Isoliermaterialen 27 voneinander getrennt sind. Mit dem Joch 26 ist eine elektromagnetische Spule 28 zur Erzeugung des magnetischen Feldes in dem ferromagnetischen Gitter gekoppelt. Vorzugsweise ist eine gitterartige Beschleunigungselektrode 29 in der Nähe des ferromagnetischen Gitters 25 und parallel zu ihm auf der gleichen Seite wie das Substrat 22 angeordnet. Die Gitterelektrode 29 und das magnetische Gitter 25 sind so befestigt, daß ihre Öffnungen ausgerichtet sind und sind durch Blöcke 30 aus Isoliermaterial voneinander getrennt. Ein Gleichspannungspotential, das von 100 bis 2000 Volt veränderbar ist, und in diesem Ausführungsbeispiel 500 Volt beträgt, wird von einer variablen Spannungsversorgungseinheit 31 zwischen dem magnetischen Gitter 25 und der Elektrode 29 angelegt, wobei der positive Pol mit der Elektrode 29 verbunden ist, um die negativen Ionen/Radikale auf das Substrat 22 hin zu beschleunigen, das die Siliciumscheiben 24 trägt. Die Beschleunigungselektrode 29 wird mittels einer variablen Spannungsversorgungseinheit 32 auf einem positiven Potential gehalten. Das Substrat 22 befindet sich vorzugsweise auf Massepotential. Durch Einstellen des Potentials zwischen der Beschleunigungselektrode 29 und dem Substrat 22 können im wesentlichen parallele Seitenwände geätzt werden mit sehr großer Ätzgeschwindigkeit oder es kann alternativ, wenn das erwünscht ist, ein laterales Ätzen zusammen mit einem vertikalen Ätzen bei einer verminderten Ätzgeschwindigkeit erreicht werden.

Bei einem anderen Ausführungsbeispiel, das in Fig. 2 dargestellt ist, enthält der Reaktionsapparat eine Hochvakuumkammer 100, die in einen oberen Teil 111 geteilt ist, dem das das Plasma bildende Gas über das von einem Ventil gesteuerte Rohr 112 zugeführt wird. Der obere Teil 111 und ein unterer Teil 114, der mit einer Vakuumpumpe 115 verbunden ist, schließen eine obere Platte oder Zielelektrode 116 aus lietendem Material ein, die auf einer elektrisch isolierender Dichtung 117 ruht, die von den oberen Enden der Seitenwände 118a, 118b getragen wird. Zwischen der Zielelektrode 116 und den Seitenwänden 118a des oberen Teiles 111 ist eine Hochfrequenzquelle 119 angeschlossen zur Lieferung von Energie an das Gas, um ein Plasma zu bilden. Normalerweise ist die Frequenz des angelegten Hochfrequenzpotentials größer als die Resonanzfrequanz der Plasmaionen in der Glimmstrecke des Plasmas und niedriger als die Resonanzfrequenz der Elektronen des Plasmas. Durch Verändern der Anordnung der Hochfrequenzquelle und des Abstandes und der Abmessungen der Elektroden kann bewirkt werden, daß das gewünschte Phänomen, das heißt Ätzen, eintritt und daß es optimiert wird. Beim reaktiven Ätzen beträgt die Hochfrequenz 13,56 MHz, aber sie kann auch 27,1 oder 40,6 MHz betragen.

Die Magnetvorrichtung ist zwischen dem oberen Teil 111 und dem unteren Teil 114 der Vakuumanlage 110 so angeordnet, daß, wenn ein positives Potential an den unteren Teil 114 angelegt wird, um die negativen Ionen und/oder Radikale anzuziehen, ein Magnetfeld aufgebaut wird, das im wesentlichen senkrecht zu der Richtung des Ionenweges verläuft und eine Stärke aufweist, die ausreicht, um die Elektronen am Erreichen des Substrates zu hindern, die jedoch nicht ausreicht, um die negativen Ionen daran zu hindern, mit den Halbleiterscheiben 124 auf dem Substrat 122 zu reagieren. Die Magnetvorrichtung enthält eine als Quelle dienende Gitterelektrode 125, die ferromagnetisches Material enthält, das aus Weicheisen besteht und die ein Joch 126 zur Vervollständigung des magnetischen Weges von einer Seite 126a zu der anderen 126b aufweist, wobei die Elektrode 125 und das Joch 126 elektrisch voneinander getrennt sind durch Isolatoren 127. Mit dem Joch 126 ist eine elektromagnetische Spule 128 gekoppelt zur Erzeugung des magnetischen Feldes in der ferromagnetischen Gitterelektrode. Vorzugsweise ist eine Beschleunigungselektrode 129 in der Nähe der Gitterelektrode 125 und parallel zu ihr angebracht auf der gleichen Seite des Substrates 122. Die Gitterelektrode 129 und das magnetische Gitter 125 sind so befestigt, daß ihre Öffnungen ausgerichtet sind und sind durch isolierende Blöcke 130 getrennt. Ein Gleichspannungspotential, das von 100 bis 2000 Volt veränderbar ist und in diesem Fall 500 Volt beträgt, wird von einer veränderbaren Gleichspannungsquelle 131 der

Gitterelektrode 125 und der Beschleunigungselektrode 129 zugeführt, um die negativen Ionen/Radikale auf das Substrat 122 hin zu beschleunigen, das hier die Siliciumscheiben 124 trägt. Das Substrat 122 befindet sich vorzugsweise auf Masse-potential. Die Beschleunigungselektrode 129 wird auf einem positiven Potential gehalten mittels einer variablen Gleichspannungsquelle 132. Wieder kann die Potentialdifferenz eingestellt werden, um die Ätzgeschwindigkeit und die Art der Ätzung, d.h. vertikal oder vertikal und seitlich, einzustellen. In Fig. 3 sind die Gitterelektroden 25 (Fig. 1) und 125 (Fig. 2) detaillierter dargestellt, die nichtmagnetische Auflagegleider 33, 34 aufweisen und die die Vorder- und Rückwände der Vakuumkammer 10 (Fig. 1) bilden. Die Auflageglieder 33, 34 bestehen aus Graphit, jedoch können auch andere nichtmagnetische Materialien verwendet werden, wenn sie vakuumbeständig sind. Die einzelnen ferromagnetischen Stangen 25a, 25b, 25c, 25d und 25e sowie das Joch 26 erstrecken sich seitlich zwischen den Auflagegliedern 33, 34. Die Kanten der Stangen 25a-e sind abgeschrägt, um das magnetische Feld in den Spalten 35, die in diesem Beispiel 1 mm betragen, weiter zu verfeinern. Alternativ können die magnetisch nichtleitenden Auflageglieder 33, 34 auch unter der ferromagnetischen Stange liegen und dazu dienen, die Öffnungen in dem Gitter zu definieren. Die gewünschte magnetische Feldstärke in den Spalten ist eine Funktion des elektrischen Feldes, das zwischen der Elektrode 25 und der Beschleunigungselektrode 29 erzeugt wird. Vorzugsweise beträgt der Zwischenraum 37 zwischen den Elektroden 25 und 29 etwa 2 mm und die magnetische Flußdichte beträgt 95 mT.

Um beispielsweise ein Elektron daran zu hindern, den in Fig. 4 dargestellten Spalt 35 zu passieren, wenn 1000 Volt zwischen der Elektrode 25 und der Beschleunigungselektrode 29 angelegt werden, die einen Abstand von 2 mm aufweisen, wäre eine magnetische Flußdichte von 135 mT erforderlich. Unter diesen Bedingungen folgt das symbolisch als $e^-$ dargestellte Elektron unter dem Einfluß der konkurrierenden elektrischen und magnetischen Krafte dem mit 36 bezeichneten Weg, der zwischen den Pfeilen einen vertikalen Abstand von etwa 0,5 mm aufweist. Daher gelangt das Elektron nicht hinter den Spalt und aus dem Plasma heraus.

Die Größe der magnetischen Flußdichte wird durch die folgende Gleichung bestimmt:

$$B = \frac{mv}{qR} = \frac{\sqrt{2mE}}{qR}$$

in der

R = 0,25 mm
E = 100 eV
m = Elektronenmasse
q = Elektronenladung

und daher

$$B = \frac{[2 \times 9{,}1 \times 10^{-31} Kg \times 10^2 \times 1{,}6 \times 10^{-19} Kg\ m^2/sec^2]^{1/2}}{1{,}6 \times 10^{-19}\ coul \times 0{,}25 \times 10^{-3} m}$$

$$B = \frac{[29{,}2 \times 10^{-48}\ Kg^2 m^2/sec^2]^{1/2}}{0{,}4 \times 10^{-22}\ coul\ m}$$

$$B = \frac{5{,}4 \times 10^{-24} Kg\ \not{m}/\ sec}{0{,}4 \times 10^{-22}\ coul\ \not{m}}$$

$$B = 13{,}5 \times 10^{-2}\ Kg/coul\ sec$$

$$B = 0{,}135\ Tesla$$

**Patentansprüche**

1. Verfahren zum reaktiven Ionenätzen, bei dem in einem Abstand vom zu ätzenden Substrat ein Plasma erzeugt wird, dadurch gekennzeichnet, daß dessen negative Ionen durch ein elektrisches Potential in Richtung auf das Substrat beschleunigt werden, und daß im Raum zwischen dem Plasma und dem Substrat senkrecht zur Bewegungsrichtung der negativen Ionen ein magnetisches Feld solcher Stärke erzeugt wird, daß Elektronen nicht zum Substrat gelangen können, sondern nur die schwereren negativen Ionen.

2. Verfahren nach Anspruch 1, dadurch gekennzeichnet, daß der Strom der negativen, zum Substrat gelangenden Ionen sehr reaktionsfreudige elektronegative Ionen enhält.

3. Verfahren nach den Ansprüchen 1 und 2, dadurch gekennzeichnet, daß ein großer Teil der elektronegativen Ionen in atomarer Form vorliegt.

4. Verfahren nach den Ansprüchen 1 bis 3, dadurch gekennzeichnet, daß der zum Substrat gelangende Ionenstrom aus einem Halogen stammt.

5. Verfahren nach den Ansprüchen 1 bis 4, dadurch gekennzeichnet, daß als Substrat ein Metall, Silicium, Siliciumoxide oder Siliciumnitride verwendet werden.

6. Verfahren nach den Ansprüchen 1 bis 5, dadurch gekennzeichnet, daß das elektrische Potential so gewählt wird, daß die negativen Ionen genügend Energie erhalten, um das Substrat sowohl physikalisch als auch chemisch zu ätzen, wodurch das laterale Ätzen des Substrates verringert wird.

7. Einrichtung zur Durchführung des Verfahrens nach den Ansprüchen 1 bis 6, dadurch gekennzeichnet, daß die erforderliche Vakuumkammer (10; Fig. 1) unterteilt ist in einen oberen Teil (11), der der Erzeugung eines aus negativen und positiven Ionen sowie aus Radikalen bestehenden Plasmas dient, und in einen unteren Teil (14), der eine Vorrichtung (25, 26a, 26b, 27, 28) zum Erzeugen eines magnetischen Feldes zwischen dem Plasma und dem zu ätzenden Substrat enthält, das senkrecht zur Bewegungsrichtung der negativen Ionen wirkt und eine solche Stärke aufweist, daß Elektronen nicht zum Substrat gelangen können, sowie eine zwischen der Vorrichtung zum Erzeugen des magnetischen Feldes und dem Substrat angeordnete Elektrode (29), die an ein variables elektrisches Potential anschließbar ist zur Beschleunigung der negativen Ionen zum Substrat.

8. Einrichtung nach Anspruch 7, dadurch gekennzeichnet, daß die Vorrichtung zum Erzeugen eines magnetischen Feldes ein Gitter (25) aus ferromagnetischem Material enthält.

9. Einrichtung nach den Ansprüchen 7 und 8, dadurch gekennzeichnet, daß das Gitter aus ferromagnetischem Material auch als Quellenelektrode zur Erzeugung des Plasmas dient.

**Revendications**

1. Procédé de décapage par ion réactif, dans lequel on produit un plasma à une distance du substrat à décaper, caractérisé en ce que les ions négatifs de ce plasma sont accélérés par un potentiel électrique dans la direction du substrat et en ce que l'on produit dans l'espace entre le plasma et le substrat, perpendiculairement à la direction du mouvement des ions négatifs, un champ magnétique d'une force telle que seuls les ions négatifs plus lourds puissent atteindre le substrat à l'exclusion des électrons.

2. Procédé selon la revendication 1, caractérisé en ce que le courant des ions négatifs atteignant le substrat contient des ions électronégatifs extrêmement réactifs.

3. Procédé selon les revendications 1 et 2, caractérisé en ce qu'une grande partie des ions électronégatifs est présente à l'état atomique.

4. Procédé selon les revendications 1 à 3, caractérisé en ce que le courant d'ions arrivant au substrat est obtenu à partir d'un halogène.

5. Procédé selon les revendications 1 à 4, caractérisé en ce que l'on utilise comme substrat un métal, du silicium, de l'oxyde de silicium ou du nitrure de silicium.

6. Procédé selon les revendications 1 à 5, caractérisé en ce que l'on choisit le potentiel électrique de telle sorte que les ions négatifs ont suffisamment d'énergie pour décaper le substrat physiquement aussi bien que chimiquement, ce qui diminue le décapage latéral du substrat.

7. Dispositif pour réaliser le procédé selon les revendications 1 à 6, caractérisé en ce que la chambre à vide utile (10; figure 1) est divisée en une partie supérieure (11) servant à produire un plasma comportant des ions négatifs et positifs ainsi que des radicaux, et en une partie inférieure (14) qui comporte un dispositif (25, 26a, 26b, 27, 28) pour produire un champ magnétique entre le plasma et le substrat à décaper, ledit champ magnétique agissant perpendiculairement à la direction de mouvement des ions négatifs et ayant und force telle que les électrons ne puissent pas arriver au substrat, et en ce que entre le dispositif pour produire le champ magnétique et le substrat est disposée und électrode (29) qui peut être connectée à un potentiel électrique variable pour accélérer les ions négatifs vers le substrat.

8. Dispositif selon la revendication 7, caractérisé en ce que le dispositif pour produire un champ magnétique comprend une grille (25) d'un matériau ferromagnétique.

9. Dispositif selon les revendications 7 et 8, caractérisé en ce que la grille de matériau ferromagnétique sert également d'électrode de source pour produire le plasma.

**Claims**

1. Process for reactive ion etching wherein a plasma is created in spaced relationship with respect to a substrate to be etched, characterized in that the negative ions in the plasma are accelerated towards the substrate by an electric potential, and in that a magnetic field is generated in the space between the plasma and the substrate, the magnetic field being orthogonal to the direction of movement of the negative ions and of a strength sufficient to retain the electrons but insufficient to prevent the heavier negative ions from reaching the substrate.

2. The process of claim 1, characterized in that the current of negative ions reaching the substrate includes highly reactive electronegative ions.

3. The process of claims 1 and 2, characterized in that a large fraction of the electronegative ions is present in the atomic state.

4. The process of claims 1 to 3, characterized in that the flow of ions reaching the substrate originates from halogen.

5. The process of claims 1 to 4, characterized in that the substrate is selected from the group consisting of metals, silicon, and oxides and nitrides of silicon.

6. The process of claims 1 to 5, characterized in that the potential is such that the negative ions obtain sufficient energy to etch the substrate physically as well as chemically, thereby minimizing lateral etching of the substrate.

7. Apparatus for performing the process according to claims 1 to 6, characterized in that the necessary vacuum enclosure (10; Fig. 1) is divided into an upper portion (11) for generating the plasma, consisting of negative and positive ions as well as radicals, and a lower portion (14) comprising means (25, 26a, 26b, 27, 28) for generating a magnetic field between the plasma and the substrate to be etched, the field acting orthogonal to the direction of movement of the negative ions and having a strength sufficient to prevent electrons from reaching the substrate, the vacuum enclosure further including an electrode (29) disposed between the magnetic field generating means and the substrate, the electrode being connectable to a variable electrical potential to accelerate the negative ions towards the substrate.

8. Apparatus as claimed in claim 7, characterized in that the magnetic field generating means comprises a ferromagnetic grid (25).

9. Apparatus as claimed in claims 7 and 8, characterized in that the ferromagnetic grid also serves as a source electrode for the plasma.

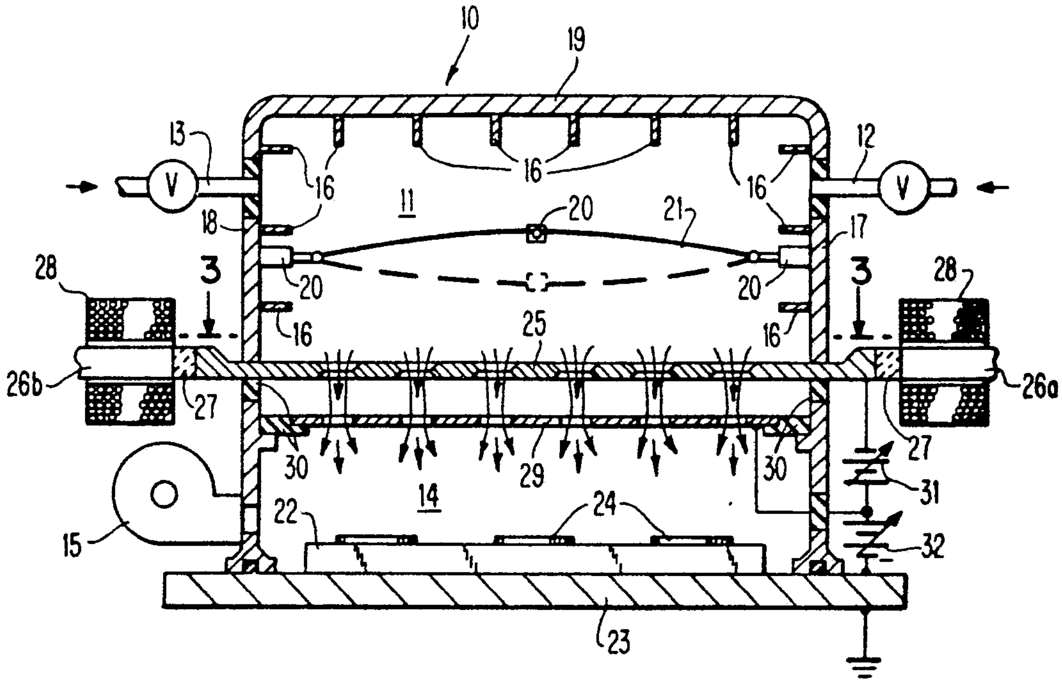
10
19
13
12
V
V
16
16
16
16
18
11
20
21
17
20
20
28
3
3
28
16
16
25
26b
27
26a
27
30
29
30
31
14
22
24
32
15
23

FIG. 1

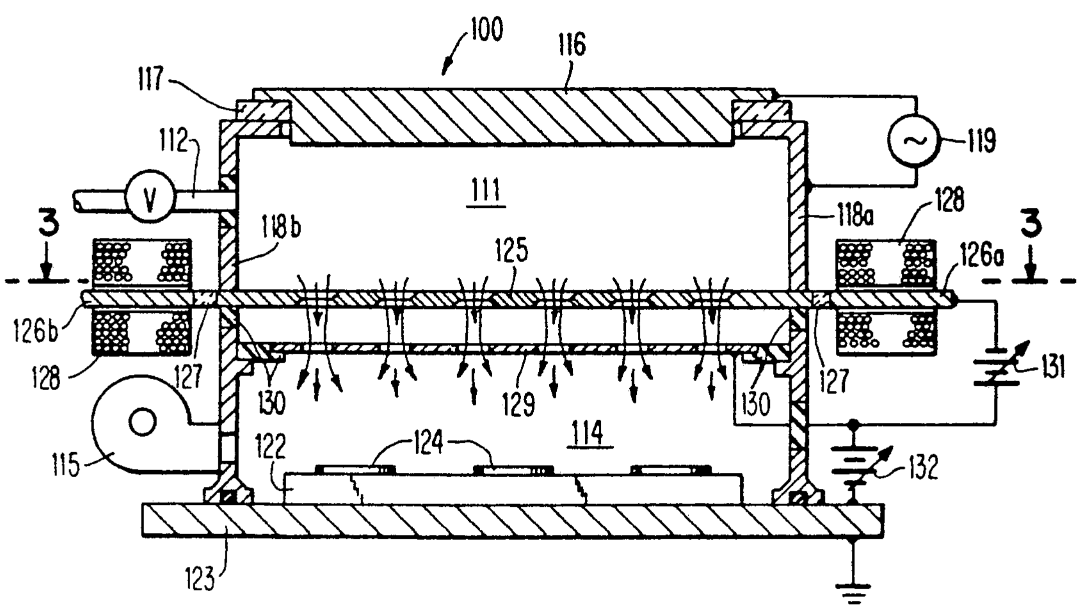
100
116
117
119
112
V
111
118b
118a
128
3
3
125
126a
126b
127
127
128
131
130
129
130
114
115
122
124
132
123

FIG.2

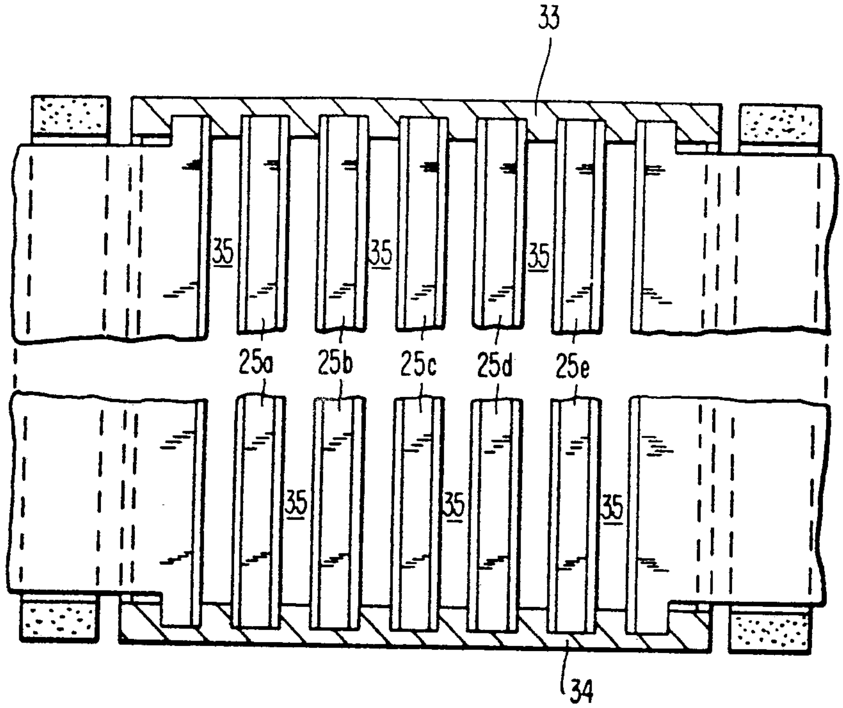


FIG.3

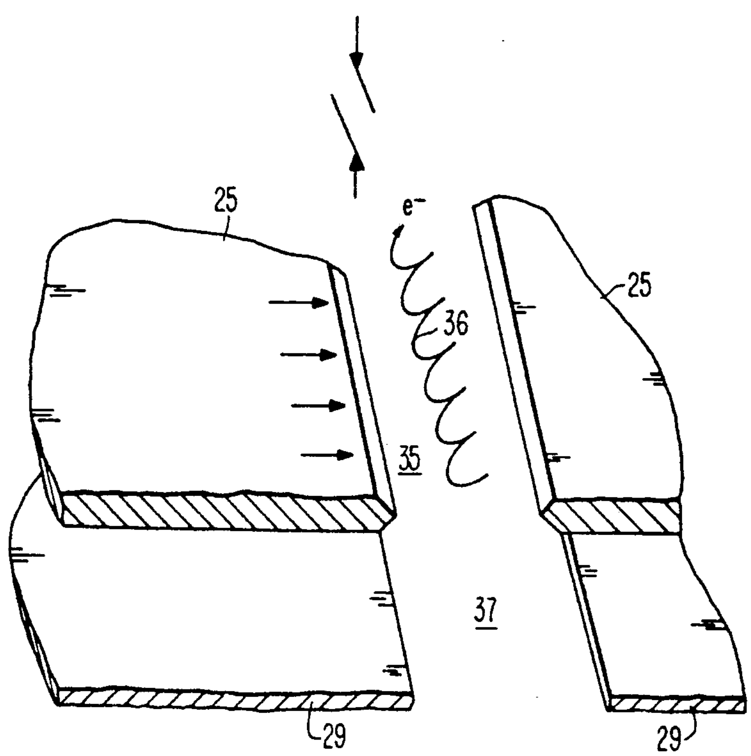


FIG.4